(19) Europäisches Patentamt
European Patent Office
Office européen des brevets

(11) **EP 2 280 425 A2**

(12) **EUROPÄISCHE PATENTANMELDUNG**

(43) Veröffentlichungstag:
**02.02.2011 Patentblatt 2011/05**

(51) Int Cl.:
*H01L 31/18* (2006.01)   *H01L 31/0224* (2006.01)
*H01L 21/70* (2006.01)   *H05K 3/12* (2006.01)
*H05K 1/09* (2006.01)   *H05K 3/40* (2006.01)
*H01L 31/048* (2006.01)   *C09D 5/24* (2006.01)
*B41M 1/34* (2006.01)

(21) Anmeldenummer: **10162578.8**

(22) Anmeldetag: **11.05.2010**

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**BA ME RS**

(30) Priorität: **19.05.2009   DE 102009025845**
**01.09.2009   DE 102009043916**

(71) Anmelder: **SCHOTT Solar AG**
**55122 Mainz (DE)**

(72) Erfinder:
• **Nagel, Dr., Henning**
**63755 Alzenau (DE)**
• **Schmidt, Wilfried**
**74193 Schwaigern (DE)**
• **Schwirtlich, Dr., Ingo**
**63897 Miltenberg (DE)**
• **Franke, Dr., Dieter**
**6291 Vaals (NL)**

(74) Vertreter: **Stoffregen, Hans-Herbert**
**Patentanwalt**
**Friedrich-Ebert-Anlage 11b**
**63450 Hanau (DE)**

(54) **Verfahren zur Herstellung elektrischer Kontakte auf einem Halbleiterbauelement**

(57)     Die Erfindung bezieht sich auf ein Verfahren zur Herstellung streifen- und/oder punktförmiger elektrisch leitender Kontakte auf einem Halbleiterbauelement, wie Solarzelle, umfassend zumindest die Verfahrensschritte (a) Aufbringen eines die Kontakte bildenden feuchten Materials in gewünschter streif- und/oder punktförmiger Anordnung auf zumindest einer Außenfläche des Halbleiterbauelements,
(b) Trocknen des feuchten Materials durch Erwärmen des Halbleiterbauelements auf eine Temperatur $T_1$ und Halten des Halbleiterbauelements bei der Temperatur $T_1$ über eine Zeit $t_1$,
(c) Sintern des getrockneten Materials durch Erwärmen des Halbleiterbauelements auf eine Temperatur $T_2$ und Halten des Halbleiterbauelements bei der Temperatur $T_2$ während einer Zeit $t_2$,
(d) Abkühlen des Halbleiterbauelements auf eine Temperatur $T_3$, die gleich oder in etwa gleich Raumtemperatur ist und Halten des Halbleiterbauelements bei der Temperatur $T_3$ über eine Zeit $t_3$,
(e) Abkühlen des Halbleiterbauelements auf eine Temperatur $T_4$ mit $T_4 \leq -35$ °C und Halten des Halbleiterbauelements bei der Temperatur $T_4$ über eine Zeit $t_4$, und
(f) Erwärmen des Halbleiterbauelements auf Raumtemperatur.

EP 2 280 425 A2

**Beschreibung**

Die Erfindung bezieht sich auf ein Verfahren zur verbesserten Herstellung streifen- und/oder punktförmiger elektrisch leitender Kontakte auf einem Halbleiterbauelement, wie Solarzelle. Auch nimmt die Erfindung Bezug auf ein Verfahren zur Herstellung eines Verbunds von Halbleiterbauelementen, wie Solarmodul.

Bei der Herstellung elektronischer Bauelemente erfolgt das Aufbringen feiner elektrisch leitender Strukturen in erster Linie über physikalische und chemische Gasphasenabscheidung, galvanische Verfahren unter Verwendung von Masken oder eventuell mit zusätzlicher Laserunterstützung. Diese Techniken erlauben die Herstellung sehr feiner Strukturen, gleichwenn diese für eine kostengünstige Massenproduktion aus wirtschaftlichen Gründen kaum geeignet sind.

Bei der Herstellung von Solarzellen besteht hinsichtlich der strahlungszugewandten Seite die Anforderung, möglichst feine elektrisch leitende Strukturen aufzubringen, die eine gute elektrische Leitfähigkeit sowie einen guten elektrischen Kontakt zur Solarzelle sicherstellen. Diese Forderung ergeht vor dem Hintergrund, dass die der Strahlung zugewandte Fläche so gering wie möglich abzuschatten ist.

Um jedoch eine gute elektrische Leitfähigkeit mit hoher Stromableitung zu ermöglichen, müssen die entsprechenden Leiter einen großen Querschnitt aufweisen.

Um diesen Forderungen zu genügen, werden nach dem Stand der Technik Kontakte häufig mittels Siebdruck aufgebracht, die durch galvanische Verfahren verstärkt werden können.

Nach der WO-A-91/24934 wird eine elektrisch leitende Paste auf einen Träger aufgebracht, die durch Bestrahlung mit UV Licht polymerisiert und stabilisiert wird.

Um eine Struktur auf einem Plasmaschirm auszubilden, ist es nach der US-B-6,312,864 bekannt, eine Substanz mit durch Hitze zu zersetzende Bindemittel aufzutragen, die sodann durch Temperatureinwirkung ausgehärtet werden.

Die US-B-6,322,620 schlägt das Aushärten einer Substanz auf einem Träger durch thermische Behandlung vor.

Aus der JP-A-63268773 ist eine Paste bekannt, die lösungsmittelfrei ist und ein Edelmetallpulver, Glasfritte, Metalloxid sowie Bindemittel enthält.

Beim Aufbringen pastenförmiger Substanzen zur Ausbildung von elektrisch leitenden Kontakten können Druckverfahren zur Anwendung gelangen. Diese zeigen jedoch grundsätzlich den Nachteil, dass bei geringer Linienbreite keine hohe Schichtdicke erzeugbar ist. Dies führt zu dem Nachteil, dass breitere Linien oder eine größere Anzahl dieser erforderlich sind, um die gewünscht niedrigen Kontaktwiderstandswerte zu erzielen.

Aus der WO-A-2005/088730 ist ein Verfahren zum Ausbilden eine linien- und/oder punktförmigen Struktur auf einer Solarzelle bekannt, bei dem eine auf dem Träger haftende elektrisch leitende pastenförmige Substanz aufgetragen wird, die ein Lösungsmittel enthält. Um ein Zerfließen des streifenförmigen Materials nach dem Auftragen und vor dem Aushärten zu vermeiden bzw. zu erreichen, dass sich die Streifen nach dem Auftragen breitenmäßig zusammenziehen, wird vorgeschlagen, dass nach Auftragen des pastenförmigen Materials auf dieses ein Medium aufgebracht wird, das polare Moleküle enthält und das zumindest teilweise das Lösungsmittel extrahiert wird.

Bei dem die polare Moleküle enthaltenden Medium handelt es sich insbesondere um ein tensidisches Medium in Form einer Flüssigkeit oder eines Schaums.

Um zu vermeiden, dass sich Solarzellen mit einem flächigen Rückkontakt, der aus Aluminium bestehen kann, während des Herstellungsprozesses durchbiegen, ist nach der DE-B-10 2005 026 176 vorgesehen, dass nach Aufbringen des flächigen Rückkontakts die Solarzelle auf eine Temperatur oberhalb von 567 °C erwärmt und sodann unterhalb der Fertigungsumgebungstemperatur der Solarzelle abgekühlt wird. Bevorzugte Temperaturbereiche liegen zwischen 0 °C und -40 °C.

Entsprechende Solarzellen werden üblicherweise zu Modulen verschaltet, in denen die Solarzellen in Kunststoffschichten, vorzugsweise aus Ethylenvinylacetat (EVA), eingebettet sind. Frontseitig ist das Modul vorzugsweise von einer Glasscheibe oder einer sonstigen transparenten Platte abgedeckt und rückseitig von z.B. einer Kunststoffverbundfolie.

Feuchtigkeit, die in das Modul eindringt, hohe Temperaturen sowie UV-Einstrahlung können dazu führen, dass Essigsäure bei der Verwendung von EVA entsteht, die mit den Kontakten und den im Glas vorhandenen Metallen Acetate bilden kann, wodurch die Kontakte korrodieren können.

In der DE-A-10 2006 005 026 wird ein Verfahren zur Herstellung von flächigen transparenten Metalloxidschichten beschrieben. Hierzu werden ein elektrisch leitfähiges Metalloxid und ein Dispersionsmittel in Form einer Schicht auf ein Substrat aufgebracht und sodann durch Mikrowellenstrahlung gesintert. Zwischen dem Auftragen und dem Sintern kann ein Trocknungsschritt durchgeführt werden.

Der vorliegenden Erfindung liegt die Aufgabe zugrunde, die Verfahren der eingangs genannten Art so weiterzubilden, dass die lokal aufgebrachten Kontakte, wie Frontkontakte und/oder je nach Design des Halbleiterbauelements auch lokal auf der Rückseite vorhandene Kontakte eine erhöhte Korrosionsbeständigkeit gegenüber sauren Medien, insbesondere organischen Säuren wie Essigsäure, Ameisensäure, Zitronensäure, Oxalsäure, aber auch gegen anorganische Säuren, wie z.B. HCl, Kohlensäure oder sonstigen korrosiven Bestandteilen wie Lothilfsmitteln, die organische polare Lösungsmittel aufweisen, sowie generell gegenüber Protonen freisetzenden Medien gegeben ist.

Nach einem weiteren Aspekt soll eine verbesserte Korrosionsbeständigkeit gegenüber alkalischen Medien, wie verdünnte anorganische oder organische Laugen sowie deren Mischungen mit anderen Verbindungen, die zu einem im basischen Bereich liegenden pH-Wert > 7 führen, erzielt werden.

Nach einer weiteren Teilaufgabe soll der Wirkungsgrad von entsprechenden Halbleiterbauelementen, insbesondere Solarzellen, im Vergleich zu den nach den bekannten Verfahren hergestellten verbessert werden.

Zur Lösung der Aufgaben bzw. Teilaufgaben sieht die Erfindung ein Verfahren zur Herstellung streifen- und/ oder punktförmiger elektrisch leitender Kontakte auf einem Halbleiterbauelement, wie Solarzelle, vor, das zumindest nachfolgende Verfahrensschritte umfasst:

(a) Aufbringen eines die Kontakte bildenden feuchten Materials in gewünschter streifen- und/oder punktförmiger Anordnung auf zumindest einer Außenfläche des Halbleiterbauelements,
(b) Trocknen des feuchten Materials durch Erwärmen des Halbleiterbauelements auf eine Temperatur $T_1$ und Halten des Halbleiterbauelements bei der Temperatur $T_1$ über eine Zeit $t_1$,
(c) Sintern des getrockneten Materials durch Erwärmen des Halbleiterbauelements auf eine Temperatur $T_2$ und Halten des Halbleiterbauelements bei der Temperatur $T_2$ während einer Zeit $t_2$,
(d) Abkühlen des Halbleiterbauelements auf eine Temperatur $T_3$, die gleich oder in etwa gleich Raumtemperatur ist, und Halten des Halbleiterbauelements bei der Temperatur $T_3$ über eine Zeit $t_3$,
(e) Abkühlen des Halbleiterbauelements auf eine Temperatur $T_4$ mit $T_4 \leq$ -35 °C und Halten des Halbleiterbauelements bei der Temperatur $T_4$ über eine Zeit $t_4$, und
(f) Erwärmen des Halbleiterbauelements auf Raumtemperatur.

Ein Verfahren zum Herstellen eines Verbunds für Halbleiterbauelemente, die auf zumindest einer Seite streifen- und/oder punktförmige elektrisch leitende Kontakte aufweisen, insbesondere zum Verschalten von Solarzellen zu einem Modul, umfasst zur Lösung der der Erfindung zugrunde liegenden Aufgabe bzw. Aufgabenteile im Wesentlichen die Verfahrensschritte:

(I) Verbinden der Halbleiterbauelemente untereinander durch Erhitzen der Halbleiterbauelemente zumindest im Bereich der Kontakte auf eine Temperatur $T_I$ mit 120 °C $\leq T_I \leq$ 370 °C und Halten über eine Zeit $t_I$,
(II) Verkapseln der Halbleiterbauelemente bei einer Temperatur $T_{II}$ und Halten über eine Zeit $t_{II}$,
(III) Einstellen der verkapselten Halbleiterbauelemente auf eine Temperatur $T_{III}$ mit 20 °C $\leq T_{III} \leq$ 90 °C und Halten über ein Zeit $t_{III}$, wobei die verkapselten Halbleiterbauelemente einer korrosiven Umgebung ausgesetzt sind,
(IV) Abkühlen der verkapselten Halbleiterbauelemente auf eine Temperatur $T_{IV}$ mit 20 °C $\geq T_{IV} \geq$ -40 °C und Halten der verkapselten Halbleiterbauelemente über eine Zeit $t_{IV}$ und
(V) Erwärmen oder Halten der verkapselten Halbleiterbauelemente auf Raumtemperatur

Erfindungsgemäß wird das Halbleiterbauelement, welches in einem ersten Ausführungsbeispiel eine Solarzelle aus kristallinen Silizium sein kann, einer Temperaturabfolge oder -sequenz mit zumindest vier Temperaturhaltepunkten unterzogen, die ein Trocknen bei einer Temperatur $T_1$ bei einer Zeit $t_1$, ein Sintern bei einer Temperatur $T_2$ bei einer Zeit $t_2$, ein Abkühlen auf Raumtemperatur und ein Abkühlen auf eine Temperatur $T_4 \leq$ -35 °C bei einer Zeit $t_4$ umfasst, sofern man das Aufheizen von Raumtemperatur auf die Temperatur, in der der Trockenprozess durchgeführt wird, und das Erwärmen von der Temperatur $T_4$ auf Raumtemperatur unberücksichtigt lässt.

Erfindungsgemäß wird des Weiteren ein Halbleiterbauelement bzw. das entsprechend dem zuvor erläuterten Verfahren hergestellte Halbleiterbauelement, welches zu einem Verbund wie Solarzellenverbund und/oder einem Solarmodul verschaltet ist, wobei das Halbleiterbauelement funktionsentsprechend in fertiger Bauweise und/oder in unterschiedlichen Fertigstellungsschritten befindlichen Zwischenzuständen vorliegen kann, einer Temperaturabfolge oder -sequenz über gewünschte Zeiten unterzogen, die Erhitzen auf die Temperatur $T_I$ und Halten vorzugsweise über eine Zeit 0,1 sec. $\leq t_I \leq$ 15 sec., ein Abkühlen auf Raumtemperatur ($\approx$ 20 °C) und anschließendem Laminieren bzw. Verkapseln der verschalteten Halbleiterbauelemente wie Solarzellen bei einer Temperatur $T_{II}$ mit 130 °C $\leq T_{II} \leq$ 160 °C über eine Zeit $t_{II}$ mit 1000 sec $\leq t_{II} \leq$ 1800 sec, ein Abkühlen auf Raumtemperatur ($\approx$ 20 °C) und anschließendem Erwärmen der verschalteten Halbleiterbauelemente auf die Temperatur $T_{III}$ mit 20 °C $\leq T_{III} \leq$ 90 °C und Halten bei dieser Temperatur $T_{III}$ über eine Zeit $t_{III}$ mit 1 sec. $\leq T_{III} \leq$ 600 sec. und das Abkühlen auf die Temperatur $T_{IV}$ bei einem Halten über eine Zeit $t_{IV}$ mit einer 1 sec. $\leq t_{IV} \leq$ 600 sec. umfasst.

Die entsprechenden Temperatur-Zeit-Folgen bzw. -Sequenzen können erfindungsgemäß auch wiederholt werden, wobei das Halbleiterbauelement bzw. die Halbleiterbauelemente in einem Klimaschrank angeordnet werden können, um den überraschenderweise positiven Effekt auf die elektrischen Kontakte bzw. Funktionalität des gesamten Halbleiterbauelements zu erzielen. Dabei ist insbesondere Temperatur und Zeit der einzelnen Verfahrensschritte in Abhängigkeit einer Materialkonstanten K bzw. K* zu wählen, die zwischen 0,02 J/cm² °C und 0,06 J/cm² °C bei den Verfahrensschritten (a) bis (f) und zwischen 0,5 J/cm$^2$ °C und 1,5 J/cm$^2$ °C bei den Verfahrensschritten (III) und (IV) liegt.

Charakteristisch für das erfindungsgemäße Verfahren bzw. die Temperaturbehandlung des Halbleiterbauelements bzw. des Verbunds von Halbleiterbauelementen ist die Abstimmung von Zeitdauer und Temperatur, die auf das Halbleiterbauelement bzw. den Verbund einwirken. Dabei ist das Halbleiterbauelement bzw. der Verbund der Halbleiterbauelemente über eine Zeit Δt einer Temperatur ΔT auszusetzen, um ein Wärme- bzw. Energieinhalt zu erzielen, der dem Produkt P = K · ΔT · Δt, bzw. P* = K* · ΔT · Δt entspricht.

Das Temperatur-Zeit-Budget und damit die Intensität der Behandlung ist folglich wesentlich für die Erfindung.

ΔT ist die Temperaturdifferenz im jeweiligen Verfahrensschritt zu 0 °C.

Die entsprechenden Materialkonstanten ergeben sich dabei aus der nachstehenden Formel:

$$K = A \times d \times \rho \times Cp \times B$$

mit:

A = Fläche des Halbleiterbauelements [cm$^2$],
d = Dicke des Halbleiterbauelements [cm],
ρ = Dichte des Halbleiterbauelements [g/cm$^3$],
Cp = Wärmekapazität des Halbleiterbauelements [J/gK],
B = Bezugsgröße auf [1/cm$^2$] des jeweils zu behandelnden Halbleiterbauelements.

Die Materialkonstante K* ergibt sich aus:

$$K* = A* \times d* \times \rho* \times Cp* \times B*$$

mit:

A* = Fläche der verschalteten Halbleiterbauelemente [cm2],
d* = Dicke der verschalteten Halbleiterbauelemente [cm],
ρ* = Dichte der verschalteten Halbleiterbauelemente [g/cm3],
Cp* = Wärmekapazität der verschalteten Halbleiterbauelemente [J/gK],
B* = Bezugsgröße auf [1/cm$^2$] verschalteten Halbleiterbauelemente wie Solarmodul.

Es hat sich gezeigt, dass durch die Temperaturbehandlungsschritte und das Einhalten von bestimmten Temperatur-Zeit-Materialkonstanten ein sicheres Anhaften des die elektrisch leitenden Kontakte bildenden Materials auf dem Halbleiterbauelement erfolgt, das auch in korrosiver Umgebung ein Ablösen ausschließt.

Dabei wird sogar überraschenderweise der Wirkungsgrad erhöht, wenn nach der Stabilisierung der Kontakte diese einer korrosiven Atmosphäre ausgesetzt sind, wie dies zum

Beispiel in einem Solarmodul der Fall sein kann, welches aus seinen verwendeten Materialien heraus zu einer korrosiven Umgebung für die verwendeten Solarzellen bzw. Solarzellenverbünde führt.

Beide positiv für die Funktion und die Langlebigkeit von Solarzellen und Solarmodulen wirkende Effekte konnten bei der erfindungsgemäßen Temperatur- bzw. Temperatur - Zeit - Materialkonstanten - Behandlung unter Berücksichtigung des Wärmeinhalts P bzw. ρ* sowohl von Solarzellen als auch von Solarmodulen in unterschiedlichen Fertigungsstadien beobachtet werden.

In Weiterbildung der erfindungsgemäßen Lehre ist daher vorgesehen, dass während des Herstellungsprozesses eine korrosive Atmosphäre, wie tensidisch, feucht, oxidativ, alkalisch, erzeugt wird, die auf das Halbleiterbauelement einwirkt. Von der Erzeugung einer korrosiven Atmosphäre kann dann Abstand genommen werden, wenn z.B. die Halbleiterbauelemente wie die Solarzellen zu einem Modul verschaltet und in einem Material eingekapselt sind, das eine korrosive Atmosphäre liefert.

Für die erfindungsgemäßen Verfahren ergeben sich insbesondere beispielhaft nachstehende Temperatur - Zeit - Materialkonstanten sowie hieraus berechnete Produkte:

|  | Temperatur [°C] | Zeit [s] | Materialkonstante [J/cm² °C] | Produkt (P = K · ΔT · Δt bzw. P = K* · ΔT · Δt) [J s/cm²] |
|---|---|---|---|---|
| Schritt (b) Trocknen | $T_{Min}$ = 100°C $T_{Max}$ = 300°C | $t_{Min}$ = 1 sek $t_{Max}$ = 600 sek | $K_{Min}$ = 0,02 $K_{Max}$ = 0,06 | $P_{Min}$ = 2 $P_{Max}$ = 10800 |
| Schritt (i) Vorsintern | $T_{Min}$ = 350°C $T_{Max}$ = 480°C | $t_{Min}$ = 1 sek $t_{Max}$ = 120 sek | $K_{Min}$ = 0,02 $K_{Max}$ = 0,06 | $P_{Min}$ = 7 $P_{Max}$ = 3456 |
| Schritt (c) Sintern | $T_{Min}$ = 720°C $T_{Max}$ = 920°C | $t_{Min}$ = 1 sek $t_{Max}$ = 120 sek | $K_{Min}$ = 0,02 $K_{Max}$ = 0,06 | $P_{Min}$ = 14,4 $P_{Max}$ = 6624 |
| Schritt (d) Lagern | $T_{Min}$ = 20°C $T_{Max}$ = 40°C | $t_{Min}$ = 1 sek $t_{Max}$ = 24 Stunden | $K_{Min}$ = 0,02 $K_{Max}$ = 0,06 | $P_{Min}$ = 0,4 $P_{Max}$ = 207360 |
| Schritt (e) Kühlen | $T_{Min}$ = -35°C $T_{Max}$ = -200°C | $t_{Min}$ = 1 sek $t_{Max}$ = 4 Stunden | $K_{Min}$ = 0,02 $K_{Max}$ = 0,06 | $P_{Min}$ = -0,7 $P_{Max}$ = -172800 |
| Schritt (I) Löten | $T_{Min}$ = 120°C $T_{Max}$ = 370°C | $t_{Min}$ = 0,1 sek $t_{Max}$ = 15 sek | $K_{Min}$ = 0,02 $K_{Max}$ = 0,06 | $P_{Min}$ = 0,24 $P_{Max}$ = 333 |
| Schritt (II) Verkapseln | $T_{Min}$ = 130°C $T_{Max}$ = 160°C | $t_{Min}$ = 1000 sek $t_{Max}$ = 1800 sek | $K^*_{Min}$ = 0,9 $K^*_{Max}$ = 1,6 | $P^*_{Min}$ = 117000 $P^*_{Max}$ = 460800 |
| Schritt(III) Kühlen | $T_{Min}$ = 20°C $T_{Max}$ = 90°C | $t_{Min}$ = 1 sek $t_{Max}$ = 600 sek | $K^*_{Min}$ = 0.5 $K^*_{Max}$ = 1,5 | $P^*_{Min}$ = 10 $P^*_{Max}$ = 81000 |
| Schritt(IV) Kühlen | $T_{Min}$ = -40°C $T_{Max}$ = 20°C | $t_{Min}$ = 1 sek $t_{Max}$ = 600 sek | $K^*_{Min}$ = 0,5 $K^*_{Max}$ = 1,5 | $P^*_{Min}$ = -20 $P^*_{Max}$ = 18000 |

Die Berechnung der Materialkonstanten ergibt sich nach den zuvor wiedergegebenen Formeln.

Bevorzugte Werte für den Wärme- bzw. Energieeintrag P der einzelnen Verfahrensschritte sind wie folgt anzugeben:

Für den Verfahrensschritt (a): $0,4 \text{ J s/cm}^2 \leq P \leq 720 \text{ J s/cm}^2$.
Für den Verfahrensschritt (b): $2 \text{ J s/cm}^2 \leq P \leq 10800 \text{ J s/cm}^2$.
Für den Verfahrensschritt (c): $288 \text{ J s/cm}^2 \leq P \leq 4416 \text{ J s/cm}^2$.
Für den Verfahrensschritt (d): $0,4 \text{ J s/cm}^2 \leq P \leq 1440 \text{ J s/cm}^2$.
Für den Verfahrensschritt (e): $-1,2 \text{ J s/cm}^2 \leq P \leq 86400 \text{ J s/cm}^2$.
Für den Verfahrensschritt (i): $7 \text{ J s/cm}^2 \leq P \leq 3456 \text{ J s/cm}^2$.
Für den Verfahrensschritt (1): $0,24 \text{ J s/cm}^2 \leq P \leq 333 \text{ J s/cm}^2$.
Für den Verfahrensschritt (m): $117000 \text{ J s/cm}^2 \leq P \leq 460800 \text{ J s/cm}^2$.
Für den Verfahrensschritt (n): $117000 \text{ J s/cm}^2 \leq P \leq 460800 \text{ J s/cm}^2$.
Für den Verfahrensschritt (I): $0,24 \text{ J s/cm}^2 \leq P^* \leq 333 \text{ J s/cm}^2$.
Für den Verfahrensschritt (II): $117000 \text{ J s/cm}^2 \leq P^* \leq 460800 \text{ J s/cm}^2$.
Für den Verfahrensschritt (III): $10 \text{ J s/cm}^2 \leq P^* \leq 81000 \text{ J s/cm}^2$.
Für den Verfahrensschritt (IV): $-20 \text{ J s/cm}^2 \leq P^* \leq 18000 \text{ J s/cm}^2$.

Bevorzugterweise wird das Halbleiterbauelement wie die Solarzelle nach dem streifen-oder punktförmigen Auftragen des feuchten Materials, das insbesondere eine pastenförmige Substanz ist, die neben Lösungsmittel Metalle wie Aluminum, Silber, Kupfer, Chrom, Vanadium, Palladium, Titan, Molybdän sowie Gläser vorzugsweise enthaltend metallische Oxide, Halbmetall, Bor, Phosphor sowie Keramiken wie $SiO_2$, Boroxid, Phosphoroxid, $Al_2O_3$, $Al_xO_y$, SiC, $Si_3Nx$ sowie Kohlenstoff unterschiedlicher Morphologie wie Ruß, Graphit, Nanotubes, Fullerene enthält, über eine Zeit $t_a$ bei Raumtemperatur gehalten werden. Während dieses Haltens sollte das Halbleiterbauelement feuchte Luft mit einem Feuchtegehalt U mit vorzugweise 20 % rel.Feuchte $\leq$ U $\leq$ 80% rel Feuchte ausgesetzt sein.

Dabei ist der Feuchtegehalt das Verhältnis der im Material enthaltenen Feuchtigkeit zur Masse des feuchtigkeitsfreien Materials.

Das pastenförmige Material wird vorzugsweise durch Drucken, Dispensen oder Inkjet aufgebracht.

Während des Haltens über die Zeit $t_a$, die zwischen 1 sec. und 600 sec. liegen kann, ist insbesondere vorgesehen, dass das feuchte Material mit einem basischen Medium oder ein basische Komponenten enthaltendes Medium kontaktiert wird. Dabei wird insbesondere ein tensidisches Medium als das basische Medium verwendet, wobei als tensidisches Medium Wasser und anionische Tenside wie Seife, Fettalkoholsulfate, Alkylbenzolsulfonate und/oder kationische Tenside wie Invertseife und/oder amphotere Tenside und/oder nichtionische Tenside wie Noncarbonsäureester von Polyalkoholen verwendet werden kann.

Insbesondere wird das tensidische Medium in Form einer Flüssigkeit oder eines Schaums im Bereich des aufgetragenen feuchten Materials auf das Halbleiterbauelement aufgebracht.

Sodann wird der Trocknungsschritt durchgeführt, wobei das Halbleiterbauelement auf die Temperatur $T_1$ zwischen 100 °C und 300 °C erhitzt wird. Bei der gewählten Endtemperatur, die vorzugsweise bei in etwa 200 °C liegt, wird das Halbleiterbauelement über eine Zeit bevorzugterweise zwischen 1 sec. und 600 sec. gehalten. Dabei sollte das Halbleiterbauelement während des Aufheizens und Haltens, zumindest während des Haltens, einer oxidierenden Atmosphäre ausgesetzt sein, die aus einem Gemisch aus Luft und Lösungsmittel und/oder Wasserdampf und/oder deren Reaktionsprodukten bestehen kann.

Mit anderen Worten wird beim Trocknungsprozess ein Grünling hergestellt.

Sodann kann das Halbleiterbauelement an Luft abgekühlt, und zwar vorzugsweise auf Raumtemperatur, gleichwenn auch nur eine Abkühlung auf eine etwas höhere Temperatur bis zu 80 °C erfolgen kann.

In einem anschließenden Aufheizprozess kann ein Erwärmen auf eine Temperatur zwischen 350 °C und 480 °C erfolgen, um restliche organische Bestanteile aus dem die elektrisch leitenden Kontakte bildenden Material auszutreiben. Das Halbleiterbauelement soll sich dabei in einer oxidierenden Atmosphäre befinden. Diese kann aus Luft mit gegebenenfalls erhöhtem Sauerstoffgehalt oder aus einer Mischung aus Luft, Bindemittel, Harz und Resten von Lösungsmitteln sowie deren Spalt- und Reaktionsprodukten (miteinander und untereinander) bestehen. Der diesbezügliche Schritt kann auch einem Vorsintern gleichkommen. Die Haltezeiten entsprechen dem Sinterschritt.

In dem nachfolgenden Sinterschritt wird das Halbleiterbauelement auf 820 °C $\pm$ 100 °C erwärmt und bei dieser Temperatur $T_2$ in oxidierender Atmosphäre über einen Zeitraum zwischen 1 sec. und 120 sec. gehalten. Als oxidierende Atmosphäre ist insbesondere Luft mit erhöhtem Sauerstoff- oder Wassergehalt zu nennen.

Beim Sintern erfolgt zunächst ein Aufschmelzen des Metallanteils zur Kontaktfläche hin, wohingegen die oberflächlichen Bereiche nur angeschmolzen sein können, um die erforderliche Verbindung zwischen den einzelnen Partikeln sicherzustellen. Selbstverständlich kann auch ein vollständiges Durchschmelzen oder ausschließlich ein oberflächliches Anschmelzen der Partikel des getrockneten feuchten Materials erfolgen, ohne dass die Erfindung verlassen wird. Auch weitere Reaktionen und nachfolgende Ergänzungsschritte, wie sie z. B. in "D. Pysch et al., Comprehensive analysis of advanced solar cell contacts consisting of printed fine-line seed layers thickened by silver plating. Progress in Photovoltaics: Research and Applications: 17:101-114" beschrieben werden, können dabei ablaufen, ohne dass die Erfindung verlassen wird.

Bevorzugterweise wird der Sinterschritt derart gesteuert, dass sich ein Schichtaufbau des streifen und/oder punktförmigen Materials derart ergibt, dass zumindest eine offenporige Außenschicht vorliegt, wobei der Volumenanteil der Poren zwischen 10 vol.% und 40 vol.%, vorzugsweise bei 25 vol.% liegt. Ferner sollte der Schichtbau derart erfolgen, dass die inneren Schichten eine höhere Dichte als die äußeren Schichten aufweisen.

Durch die Offenporigkeit der äußeren Schicht ergibt sich der Vorteil, dass alkalische Medien bzw. alkalische Komponenten eingelagert werden können, bei denen es sich z.B. um alkalische Salze wie Alkali- oder Erdalkalicarbonate handelt. Dies zeigt den Vorteil, dass dann, wenn die Halbleiterbauelemente während des Betriebs einer zu konzentrierten korrosiven Atmosphäre ausgesetzt werden, in einem Umfang ein Neutralisieren erfolgt, dass eine Beschädigung der Kontakte ausgeschlossen ist.

Die nach dem Sinterprozess vorliegenden Schichten sollten Dicken zwischen 1/10 $\mu$m und 20 $\mu$m aufweisen, wobei die Gesamthöhe des aus den Schichten bestehenden Kontakts bis zu 40 $\mu$m beträgt, um den gewünschten niedrigen elektrischen Widerstand zum Ableiten von Ladungsträgern sicherzustellen.

Des Weiteren besteht die Möglichkeit, nach dem Sinterschritt und dem Abkühlen auf Raumtemperatur oder nach dem Abkühlschritt und dem Erwärmen auf Raumtemperatur den elektrisch leitenden Kontakt zumindest bereichsweise mit einer Metallschicht abzudecken, die z.B. galvanisch aufgetragen wird.

Das Sintern sollte in oxidierender Atmosphäre erfolgen, wobei insbesondere Luft mit gegebenenfalls erhöhtem Sauerstoffgehalt die Atmosphäre bildet.

Anschließend wird das Halbleiterbauelement auf Raumtemperatur ($T_3$) abgekühlt. Nach Abkühlen auf Raumtemperatur kann dann, wenn die Halbleiterbauelemente wie Solarzellen im Durchlaufprozess prozessiert werden, ein Halten über einen Zeitraum zwischen 1 sec. und 24 h erfolgen.

Bei batchweisem Herstellen der Halbleiterbauelemente wie Solarzellen kann das erfindungsgemäß hergestellte Halbleiterbauelement in einem Lagerschritt bis zu mehreren Stunden, wie z. B. bis zu 5 h oder sogar 24 h, bei definierter Atmosphäre mit reduzierter Feuchtigkeit gehalten werden.

Anschließend erfolgt der Abkühlschritt auf die Temperatur $T_4$ unterhalb von -35 °C, insbesondere auf eine Temperatur im Bereich zwischen -35 °C und -200 °C. Das Halten bei der gewünschten Temperatur, insbesondere das Abkühlen und Halten erfolgt in einer inerten Atmosphäre. Wird eine inerte Atmosphäre gewählt, sollte diese aus Stickstoff oder Argon oder einem Gemisch dieser bestehen.

Des Weiteren kann die Umgebung des auf die tiefe Temperatur abgekühlten Halbleiterbauelements Alkohol wie Methanol und Ethanol oder Trockeneis oder feuchtigkeitsabsorbierende Salze enthalten, um Feuchtigkeit zu binden. Die Haltezeiten $t_4$ bei der Temperatur $T_4$ betragen 1 sec $\leq t_4 \leq$ 14400 sec.

Nach dem Abkühlschritt erfolgt ein Aufheizen auf Raumtemperatur, und zwar gleichfalls bevorzugterweise in einer inerten Atmosphäre oder bei trockener Luft. In der Umgebung kann Trockeneis oder Alkohol wie Methanol oder Ethanol vorgesehen sein.

Nach Aufheizen auf Raumtemperatur kann das Halbleiterbauelement bei dieser Temperatur für 1 sec. bis 24 h oder länger gehalten werden, wobei das Halbleiterbauelement einer feuchten, basischen oder sauren Atmosphäre ausgesetzt werden kann. Die Atmosphäre kann Wasser und/oder $CO_2$ und/oder Essigsäure enthalten.

Sodann werden die Halbleiterbauelemente in den Bereichen, in denen die streifen- bzw. punktförmigen elektrisch leitenden Kontakte mit elektrisch leitenden Verbindern verbunden werden sollen, auf eine Temperatur im Bereich zwischen 120 °C und 370 °C aufgeheizt. In dieser Zeit sollte das Halbleiterbauelement Luft ausgesetzt sein.

Nach dem Verbinden wie Verlöten wird das Halbleiterbauelement bei Temperaturen von 130 °C $\leq T_{II} \leq$ 160 °C verkapselt, um insbesondere bei Solarzellen ein Modul herzustellen. Vor oder während der Verkapselung können gleichfalls alkalische Komponenten zugeführt werden, die sich in den Kontakten ein- oder anlagern, um zumindest eine teilweise Neutralisation einer sauren Atmosphäre zu ermöglichen, die sich dann einstellt, wenn die Halbleiterbauelemente in Ethylenvinylacetat (EVA) eingebettet werden, das in Gegenwart von UV-Licht, Wärme und/oder Feuchtigkeit Essigsäure bildet.

Entsprechend der selbständig Schutz genießenden Lehre, nach der verschaltete Halbleiterelemente wie ein Solarmodul in unterschiedlichen Zwischenschritten seiner Fertigung eine Kombination aus Temperatur-Zeit-Materialkonstante-Abfolgen unterworfen wird, kann auch das verwendete Einbettmaterial, welches zum Aufbau des Moduls verwendet wird, zur Erzeugung einer korrosiven wie chemisch inhibitierenden Umgebung für die verwendeten Halbleiterbauelemente wie Solarzellen dienen.

Durch die zuvor beschriebenen Schrittfolgen von Temperatur und Zeit bzw. Materialkonstante werden die Kontakte derart stabilisiert, dass eine korrosive Umgebung von Solarzellen als die Halbleiterbauelemente, beim bestimmungsgemäßen Einsatz von Solarzellen in Solarmodulen, üblicherweise mindestens 20 Jahre unter Außenbewitterungszuständen in unterschiedlichen Klimazonen, nicht dazu führt, dass die Kontakte der Solarzellen sich lösen bzw. gravierend beschädigt werden. Ferner ergibt sich überraschenderweise, dass der Wirkungsgrad der Solarzelle erhöht werden kann, ohne dass ein Lösen der Kontakte von dem Halbleiterbauelement erfolgt.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung eines Beispiels.

Die erfindungsgemäße Lehre wird nachstehend anhand eines Ausführungsbeispiels näher erläutert, wobei Verfahrensschritte prinzipiell anhand der einzigen Figur nachvollzogen werden sollen. In der Figur ist dabei die bei den einzelnen Verfahrensschritten zur Anwendung gelangende Temperatur ohne Berücksichtigung von Rampen gegenüber der Zeit aufgetragen. Die Zeit ist ohne Angaben von Werten aufgetragen, um eine Prinzipdarstellung des Verfahrensablaufs zu ermöglichen. Ferner wird die erfindungsgemäße Lehre anhand einer Solarzelle als Halbleiterbauelement erläutert, ohne dass hierdurch eine Einschränkung erfolgen soll.

So kann z.B. in einem aus kristallinem p-Sillizium bestehendes Substrat durch Eindiffusion von P-Atomen eine n-leitende Emitterschicht ausgebildet werden, um in dem Substrat einen pn-Übergang zu bilden.

Sodann wird auf die Rückseite des Substrats vorzugsweise flächig eine aus Aluminium bestehende oder Aluminium enthaltende Schicht aufgetragen, die bei der fertigen Solarzelle den Rückkontakt bildet. Frontseitig werden zur Herstellung des Frontkontakts z.B. mittels Dispens- oder Inkjetverfahren eine ein Lösungsmittel enthaltende Paste streifenförmig aufgetragen (Verfahrensschritt (a)). Neben dem Lösungsmittel kann die Pasten Metalle wie Aluminium, Silber, Kupfer, Chrom, Vanadium, Palladium, Titan oder Molybdän sowie Gläser enthaltende metallische Oxide, Halbmetalle, Bor, Phosphor sowie Keramiken wie $SiO_2$, Boroxid, $Al_2O_3$, $Al_xO_y$, SiC oder $Si_3N_x$ sowie Kohlenstoff in unterschiedlichen Morphologien enthalten. Nach Auftragen der die Frontkontakte bildenden Streifen wird ein Tenside enthaltender Schaum aufgetragen, wodurch Lösungsmittel aus dem aufgetragenen Material extrahiert und somit ein Aushärten zumindest der Oberflächenschicht mit der Folge gegeben ist, dass ein Zerfließen der Streifen unterbleibt.

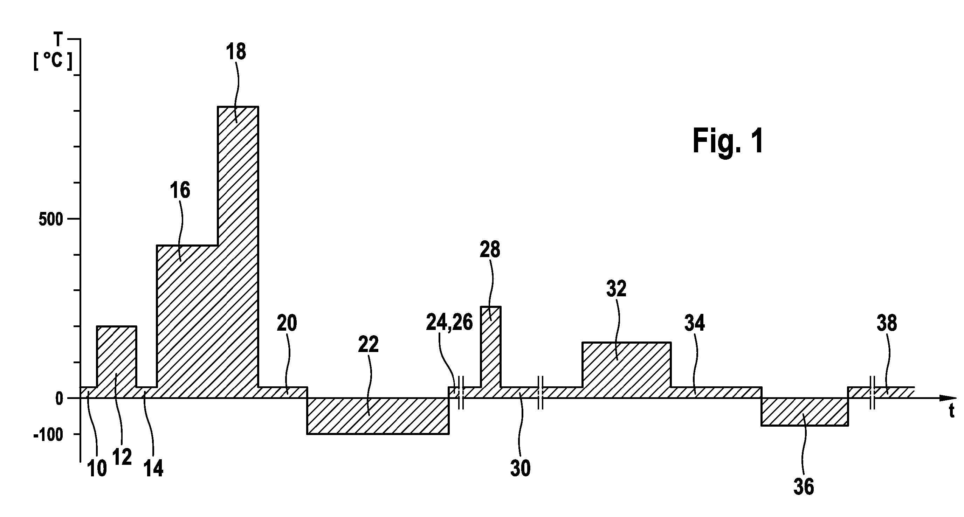

Das Auftragen des Schaums kann während eines Halteschritts bei Raumtemperatur durchgeführt werden (Bereich 10 in Fig. 1), wobei gleichzeitig eine Atmosphäre mit einem Feuchtigkeitsgehalt U vorzugsweise mit U > 50% eingestellt wird. Anschließend wird der Schaum entfernt und ein Trocknungsschritt bei einer Temperatur von in etwa 200 °C in oxidierender Atmosphäre durchgeführt (Verfahrensschritt (b) = 12). Bei der gewünschten Temperatur wird die Solarzelle über eine Zeit zwischen 1 sec und 600 sec gehalten. Anschließend kann ein erneutes Abkühlen erfolgen (Verfahrensschritt (g) = 14), um sodann bei einer Temperatur von in etwa bis 415 °C restliche organische Bestandteile aus dem zuvor pastenförmigen Material auszutreiben (Verfahrensschritt (i) = 16). Dieser Verfahrensschritt wird in oxidierender Atmosphäre durchgeführt. Sodann wird das getrocknete Material gesintert (Verfahrensschritt (c) = 18), und zwar bei einer Temperatur von in etwa 800 °C. Bei dieser Temperatur wird die Solarzelle über einen Zeitraum zwischen 20 sec. und 80 sec. in oxidierender Atmosphäre gehalten.

Die Solarzelle wird anschließend auf Raumtemperatur ($\approx$ 20 °C) abgekühlt (Verfahrensschritt (d) = 20) und kann bei Raumtemperatur über einen Zeitraum zwischen 1 sec und 600 sec in Luftatmosphäre gehalten werden, sofern im Durchlaufverfahren prozessiert wird. Wird batchweise gearbeitet, so kann ein Lagerschritt erfolgen, in dem die Solarzelle bis zu mehreren Stunden in definierter Atmosphäre mit reduzierter Feuchtigkeit gelagert wird.

Sodann wird die Solarzelle auf eine Temperatur unter -35 °C, bevorzugterweise im Bereich zwischen -60 °C und -100 °C abgekühlt (Verfahrensschritt (e) = 22), wobei eine inerte oder trockene Luft als Atmosphäre gewählt wird. Bei der tiefen Temperatur wird die Solarzelle sodann zwischen 1 sec. und 4 h gehalten. Zusätzlich kann Alkohol oder Trockeneis anwesend sein, um Feuchtigkeit zu binden. Nach dem Kühlschritt wird die Solarzelle auf Raumtemperatur bevorzugt in Luft erhitzt, wobei auch eine feuchte oder sogar korrosive Atmosphäre herrschen kann. Die Solarzelle wird nach Erwärmen auf Raumtemperatur bei dieser bzw. der Umgebungstemperatur nach Bedarf gelagert (Verfahrensschritt (f) = 24).

Während der Lagerung werden in einer Ausführungsvariante die elektrisch leitenden Kontakte mit alkalischen Salzen wie Alkali oder Erdalkalicarbonaten versehen, die dann, wenn die Kontakte einer konzentrierten sauren Atmosphäre ausgesetzt sein sollten, eine erforderliche Neutralisation bewirken. Die alkalischen Komponenten können auch in die Kontakte eingelagert werden, sofern beim Sinterprozess eine offenporige Außenschicht erzeugt wird.

Nach einer Lagerung der Solarzelle für 24 h in einer wasserdampfgesättigten Umgebung (Verfahrensschritt (k) = 26), die auch $CO_2$ und/oder Essigsäure enthalten kann, hat sich überraschenderweise gezeigt, dass die Kontakte ausreichend stabil auf der Siliciumscheibe haften, während bei Nichtbeachtung der zuvor beschriebenen Vorgaben die Kontakte mit einem Klebefilm vom Wafer abgelöst werden können. Es wurde insbesondere gefunden, dass speziell die lokalen Ag-haltigen Kontakte einen Angriff durch schwache Essigsäure mit 5- bis 10-facher Konzentration gegenüber derjenigen, bei welcher die nach dem bisherigen Stand der Technik hergestellten Kontakte sich schon teilweise mit dem Klebefilm ablösen lassen, ohne Haftfestigkeitseinbußen überstehen .

In einer Abwandlung des Ausführungsbeispieles wird die Solarzelle während der Lagerung nach Erwärmen auf Raumtemperatur für ca. 20 sec bis 600 sec. in einer alkalischen Lösung mit dem ph-Wert von 7 bis 13 und bevorzugt ca. 9 bis 11 gelagert. Auch danach konnte weiterhin eine gute Kontakthaftung beim Abrisstest mit dem Klebefilm nach bis zu 10-fach längeren Lagerzeiten gefunden werden, die bei nach dem bisherigen Stand der Technik hergestellten Kontakte schon teilweise zu Ablösungen mit dem aufgebrachten Klebefilm führten.

In beiden Varianten des Ausführungsbeispiels für eine Lagerung in korrosiver saurer oder alkalischer Umgebung konnten Wirkungsgradverbesserungen von üblicherweise 1-2 % relativ, in Einzelfällen aber auch über 5 % relativ gemessen werden.

In einer weiteren Ausgestaltung des Ausführungsbeispiels wird die Solarzelle - nach Abkühlung auf ca. -160°C mit einer Haltezeit von 60 min, nachfolgender Erwärmung auf Raumtemperatur und Lagerung in Luft für 3 Tage bei Umgebungstemperatur - in einem weiteren Schritt zumindest in den Bereichen, in denen eine elektrisch leitende Verbindung mit Verbindern z. B. durch Löten oder Kleben zur Erlangung eines Solarzellenverbundes hergestellt werden soll, auf eine Temperatur im Bereich zwischen 120 °C und 370 °C bei Luft erwärmt (Verfahrensschritt (1) bzw. (I) = 28), um nach dem Verbinden die Solarzelle bzw. den Solarzellenverbund wiederum auf Raumtemperatur abzukühlen (Verfahrensschritt (m) bzw. (II) = 30), um mit weiteren entsprechend hergestellten Solarzellen über Verbinder verschaltet und sodann in Unterdruckatmosphäre bei einer Temperatur im Bereich zwischen 130 °C bis 160 °C verkapselt zu werden (Verfahrensschritt (n) bzw. (II) = 32). Die verschalteten Solarzellen werden z.B. in Ethylenvinylacetat (EVA) eingebettet, und dabei frontseitig mit einer Glasplatte und rückseitig mit einer Kunststoffverbundfolie oder einer weiteren Glasplatte abgedeckt.

Nach anschließender Lagerung für ca. 1 Monat in feuchter Umgebung und erhöhten Temperaturen bis 80°C, teilweise kombiniert mit UV-Lichtbestrahlung, wurde festgestellt, dass durch die beschriebenen Temperaturbehandlungsschritte die erfindungsgemäß hergestellten Solarzellen innerhalb des Solarmoduls im Gegensatz zu den herkömmlich hergestellten Solarzellen nach Abschluss der Lagerung einen ca. 2 % - 3 % relativ höheren Wirkungsgrad zeigen. Dieser relative Vorteil blieb auch nach weiterer Lagerung mit einer Dauer von mehreren Monaten unter den zuvor beschriebenen Bedingungen erhalten.

Auch mit anderen Pastenzusammensetzungen unter Variation der Morphologie der Metallpartikel, der Glasfrittenzusammensetzung und/oder den organischen Bestandteilen wurden ähnliche Beobachtungen gemacht. Dabei wurde z.B. der Feststoffgehalt (Metall und Fritte) im Bereich 30-90% und der Anteil des Metalls am Gesamtfeststoffgehalt im Bereich 90-100% variiert. Außerdem wurden unterschiedliche Lösungsmittel und auch Binderharze als die üblichen organischen Bestandteile variiert.

Anschließend werden die zu einem Modul verschalteten verkapselten Solarzellen auf eine Temperatur zwischen 20 °C und 90 °C abgekühlt (Verfahrensschritt III = 34) und über eine Zeit vorzugsweise zwischen 1 sec und 600 sec gehalten. Es schließt sich ein weiterer Abkühlprozess an (Verfahrensschritt IV = 36), bei dem das Modul über einen Zeitraum zwischen 1 sec und 600 sec in einem Temperaturbereich zwischen +20 °C und -40 °C gehalten wird. Anschließend erfolgt ein Aufwärmen auf Raumtemperatur (Verfahrensschritt (V) = 38), um sodann über eine gewünschte Dauer das Modul bei dieser Temperatur zu lagern.

Die in der Fig. 1 schraffiert dargestellten Flächen entsprechen dem Produkt P, also dem Wärme- bzw. Energieinhalt der Solarzelle bzw. des Moduls aufgrund der über die Zeit t einwirkenden Temperatur T.

In einem anderen Ausführungsbeispiel wird zunächst eine dünne, nur ca. $0{,}1\,\mu m$ - $3\,\mu m$ dünne Tinten- oder Pastenschicht mit einem Inkjet- oder Transferverfahren lokal auf eine oder beide Seiten des Siliciumsubstrates aufgebracht. Dies kann bei Raumtemperatur oder einer erhöhten Temperatur bis zu 200 °C erfolgen, um bereits eine in-situ Trocknung zu erzielen. Nach einem aus Ablaufgründen erfolgten Abkühlen werden wie üblich bei ca. 400 °C - 550 °C restliche organische Bestandteile aus dem zuvor tinten-oder pastenförmigen Material in oxidierender Atmosphäre ausgetrieben. Anschließend erfolgt der Sinterschritt bei einer Temperatur von ca. 850 °C für ca. 20 sec. bis 80 sec. in oxidierender Atmosphäre. Die Solarzelle wird anschließend auf Raumtemperatur abgekühlt.

Sodann wird in einem galvanischen Prozess die so hergestellte dünne Kontaktschicht mit einem galvanischen Verfahren durch Abscheidung von Metallen wie Silber, Nickel, Kupfer oder Zinn galvanisch verstärkt, bis die gewünschte Leitfähigkeit des Gesamtkontaktes erreicht wird.

In einer Abwandlung dieses Ausführungsbeispiels wird auf die lokal aufgebrachte dünne Schicht nach der Trocknung oder nach dem Sintern eine weitere Pastenschicht mit

Siebdruck, Transferdruck oder Dispensen aufgebracht und danach ebenfalls den zuvor beschriebenen Temperaturschritten unterworfen.

Als Alternative können auch auf die gesinterte erste Kontaktschicht polymerbasierte Metallpasten in der für eine ausreichende Leitfähigkeit erforderlichen Dicke aufgebracht und bei 100 °C bis 400 °C oder unter UV-Licht ausgehärtet werden.

In einer weiteren Abwandlung dieses Ausführungsbeispiel werden bei einer rückseitig kontaktierten Solarzelle beide Kontakttypen auf der Rückseite des Siliciumsubstrats in Form von kammartigen Kontaktanordnungen, dem sogenannten ‚interdigitated contact' Design, mit den zuvor beschriebenen Abläufen aufgebracht.

Mit all diesen Ausführungsvarianten werden die zuvor beschriebenen Temperatur- Zeit Abfolgen und Lagervariationen ausgeführt. Auch damit werden vergleichbare Ergebnisse bezüglich Verbesserung der Kontakthaftung und des Wirkungsgrades durch die Einwirkung von sauren oder alkalischen Medien erzielt.

Durch die Temperaturbehandlungsschritte bzw. deren spezifische Temperatur - Zeit - Materialkonstante - Produkte und deren Abfolge (siehe z. B. Tabelle) wird erreicht, dass die elektrisch leitenden Frontkontakte im Vergleich zu bisher bekannten Kontakten gegenüber sauren Medien eine erhöhte Korrosionsbeständigkeit zeigen. Auch hat sich überraschenderweise gezeigt, dass eine korrosive Umgebung dazu führt, dass der Wirkungsgrad erhöht wird.

## Patentansprüche

1. Verfahren zur Herstellung streifen- und/oder punktförmiger elektrisch leitender Kontakte auf einem Halbleiterbauelement, wie Solarzelle, umfassend zumindest die Verfahrensschritte

   (a) Aufbringen eines die Kontakte bildenden feuchten Materials in gewünschter streifen- und/oder punktförmiger Anordnung auf zumindest einer Außenfläche des Halbleiterbauelements,

   (b) Trocknen des feuchten Materials durch Erwärmen des Halbleiterbauelements auf eine Temperatur $T_1$ und Halten des Halbleiterbauelements bei der Temperatur $T_1$ über eine Zeit $t_1$,

   (c) Sintern des getrockneten Materials durch Erwärmen des Halbleiterbauelements auf eine Temperatur $T_2$ und Halten des Halbleiterbauelements bei der Temperatur $T_2$ während einer Zeit $t_2$,

   (d) Abkühlen des Halbleiterbauelements auf eine Temperatur $T_3$, die gleich oder in etwa gleich Raumtemperatur ist, und Halten des Halbleiterbauelements bei der Temperatur $T_3$ über eine Zeit $t_3$,

   (e) Abkühlen des Halbleiterbauelements auf eine Temperatur $T_4$ mit $T_4 \leq$ -35 °C und Halten des Halbleiterbauelements bei der Temperatur $T_4$ über eine Zeit $t_4$, und

   (f) Erwärmen des Halbleiterbauelements auf Raumtemperatur.

2. Verfahren zum Herstellen eines Verbundes von Halbleiterbauelementen, die auf zumindest einer Seite streifen- und/oder punktförmige elektrisch leitende Kontakte aufweisen, insbesondere zum Verschalten von Solarzellen zu einem Modul, umfassend die Verfahrensschritte:

   (I) zum Verbinden der Halbleiterbauelemente untereinander Erhitzen der Halbleiterbauelemente zumindest im Bereich der Kontakte auf eine Temperatur $T_I$ mit 120 °C $\leq T_I \leq$ 370 °C und Halten über eine Zeit $t_I$,

(II) Verkapseln der Halbleiterbauelemente bei einer Temperatur $T_{II}$ und einer Haltezeit $t_{II}$,

(III) Abkühlen oder Halten der Halbleiterbauelemente auf eine Temperatur $T_{III}$ mit 20 °C $\leq T_{III} \leq$ 90 °C und Halten der verkapselten Halbleiterbauelemente über eine Zeit $t_{III}$, während der die verkapselten Halbleiterbauelemente einer korrosiven Umgebung ausgesetzt werden,

(IV) Abkühlen der verkapselten Halbleiterbauelemente auf eine Temperatur $T_{IV}$ mit 20 °C $\geq T_{IV} \geq$ -40 °C und Halten der verkapselten Halbleiterbauelemente über eine Zeit $t_{IV}$ und

(V) Erwärmen oder Halten der verkapselten Halbleiterbauelemente auf Raumtemperatur.

3.  Verfahren nach Anspruch 1,
    **dadurch gekennzeichnet,**
    **dass** das Halberleiterbauelement nach dem Auftragen des feuchten Materials (Verfahrensschritt (a)) bei Raumtemperatur über eine Zeit $t_a$ gehalten wird, wobei vorzugsweise das Halbleiterbauelement während der Zeit $t_a$ feuchter Luft mit einem Feuchtegehalt U mit vorzugsweise 20% relative Feuchte $\leq U \leq$ 80% relative Feuchte ausgesetzt wird, und wobei insbesondere das Halbleiterbauelement über die Zeit $t_a$ mit 1 sec $\leq t_a \leq$ 600 sec bei Raumtemperatur gehalten wird.

4.  Verfahren nach zumindest Anspruch 1,
    **dadurch gekennzeichnet,**
    **dass** nach dem Auftragen des feuchten Materials auf das Halbleiterbauelement ein basisches Medium oder ein basische Komponenten enthaltendes Medium aufgebracht wird, wobei insbesondere ein tensidisches Medium als das basische Medium verwendet wird und als tensidisches Medium Wasser und anionische Tenside wie Seife, Fettalkoholsulfate, Alkylbenzolsulfonate und/oder kationische Tenside wie Invertseife und/oder amphotere Tenside und/oder nichtionische Tenside wie Noncarbonsäureester von Polyalkoholen verwendet wird, wobei vorzugsweise das tensidische Medium in Form einer Flüssigkeit oder eines Schaums im Bereich des aufgetragenen feuchten Materials auf das Halbleiterbauelement aufgebracht wird.

5.  Verfahren nach zumindest Anspruch 1,
    **dadurch gekennzeichnet,**
    **dass** das Halbleiterbauelement zum Trocknen des feuchten Materials (Verfahrensschritt (b)) auf die Temperatur $T_1$ mit 100 °C $\leq T_1 \leq$ 300 °C erwärmt wird, insbesondere bei der Temperatur $T_1$ über die Zeit $t_1$ mit 1 sec $\leq T_1 \leq$ 600 sec gehalten wird, und vorzugsweise zumindest während des Haltens über die Zeit $t_1$, vorzugsweise während des gesamten Verfahrensschritts (b) einer oxidierenden Atmosphäre $A_1$ ausgesetzt wird, wobei bevorzugterweise ein Gemisch aus Luft und Lösungsmittel und/oder Wasserdampf und/oder Reaktions-produkten daraus als die oxidische Atmosphäre $A_1$ verwendet wird, und/oder dass das Halbleiterbauelement nach dem Verfahrensschritt (b) auf eine Temperatur $T_5$ mit Raumtemperatur (RT) $\leq T_5 \leq$ +80 °C als Verfahrensschritt (g) abgekühlt wird, wobei insbesondere das Abkühlen auf die Temperatur $T_5$ an Luft erfolgt, und/oder

    **dass** das Halbleiterbauelement nach dem Trocken (Verfahrensschritt (b)) und vor dem Sintern (Verfahrensschritt (c)) auf eine Temperatur $T_6$ mit 350 °C $\leq T_6 \leq$ 480 °C als Verfahrensschritt (i) erwärmt wird, wobei insbesondere das Erwärmen des Halbleiterbauelements auf die Temperatur $T_6$ in oxidierender Atmosphäre $A_2$ durchgeführt wird, wobei vorzugsweise als oxidierende Atmosphäre $A_2$ ein Gemisch aus Luft und Bindemittel, Harzen und/oder Lösungsmitteln oder Luft mit erhöhtem $O_2$ Gehalt ($\geq$ 21 % Vol) verwendet wird, und/oder dass das Sintern des getrockneten Materials (Verfahrensschritt (c)) bei der Temperatur $T_2$ mit 720 °C $\leq T_2 \leq$ 920 °C erfolgt und bevorzugterweise das Halbleiterbauelement bei der Temperatur $T_2$ während der Zeit $t_2$ mit 1 sec $\leq t_2 \leq$ 120 sec gehalten wird, wobei insbesondere das Sintern an Luft oder an Luft mit einem erhöhten $O_2$ Gehalt ($\geq$ 21 % Vol) durchgeführt wird.

6.  Verfahren nach zumindest Anspruch 1,
    **dadurch gekennzeichnet,**
    **dass** das Halten des Bauelements bei der Temperatur $T_3$ (Verfahrensschritt (d)) entweder über die Zeit $t_3$ mit 1 sec $\leq t_3 \leq$ 100 sec oder über die Zeit $t_3$ mit 1 sec $\leq t_3 \leq$ 24 h an Luft mit normaler Feuchtigkeit oder an Luft mit reduzierter Feuchtigkeit ($\leq$ 20% rel. Feuchte) durchgeführt wird, und/oder dass das Abkühlen des Halbleiterbauelements auf die Temperatur $T_4$ (Verfahrensschritt (e)) mit -35 °C $\leq T_4 \leq$ -200 °C durchgeführt wird, wobei vorzugsweise das Abkühlen auf die Temperatur $T_4$ in inerter Atmosphäre oder in trockener Luft durchgeführt wird, insbesondere das Halbleiterbauelement bei der Temperatur $T_4$ über die Zeit $t_4$ mit 1 sec $\leq t_4 \leq$ 2 h, insbesondere 1 sec $\leq t_4 \leq$ 4 h, gehalten wird, wobei vorzugsweise zumindest das Halten, vorzugsweise das Abkühlen und Halten des Halbleiterbauelements bei der Temperatur $T_4$ in inerter Atmosphäre oder bei trockener Luft durchgeführt wird, wobei als inerte Atmosphäre Stickstoff oder Argon oder ein Gemisch oder $CO_2$ dieser verwendet wird, und/oder

**dass** das Halbleiterbauelement während des Abkühlens auf die Temperatur $T_4$ einer Umgebung ausgesetzt wird, in der sich Trockeneis oder Alkohol wie Methanol oder Ethanol befindet.

7.  Verfahren nach zumindest Anspruch 1,
    **dadurch gekennzeichnet,**
    **dass** das Erwärmen des Halbleiterbauelements von der Temperatur $T_4$ auf Raumtemperatur (Verfahrensschritt (f)) in inerter Atmosphäre oder bei trockener Luft durchgeführt wird, wobei insbesondere als inerte Atmosphäre Stickstoff oder Argon oder $CO_2$ oder ein Gemisch dieser verwendet wird, wobei vorzugsweise während des Erwärmens des Halbleiterbauelements von der Temperatur $T_4$ auf Raumtemperatur (Verfahrensschritt (f)) das Halbleiterbauelement in einer Umgebung gehalten wird, in der sich Trockeneis oder Alkohol wie Methanol oder Ethanol befindet.

8.  Verfahren nach zumindest Anspruch 1,
    **dadurch gekennzeichnet,**
    **dass** in einem Verfahrensschritt (k) das Halbleiterbauelement nach dem Verfahrensschritt (f) bei Raumtemperatur über eine Zeit $t_6$ mit 1 sec. $\leq t_6 \leq$ 24 h oder länger gehalten wird, wobei vorzugsweise das Halbleiterbauelement während des Verfahrensschritts (k) einer feuchten, basischen oder sauren Atmosphäre ausgesetzt wird, insbesondere während des Verfahrensschritts (k) einer Atmosphäre ausgesetzt wird, die $CO_2$ und/oder Essigsäure enthält.

9.  Verfahren nach zumindest Anspruch 2 oder 8,
    **dadurch gekennzeichnet,**
    **dass** das Halbleiterbauelement nach dem Verfahrensschritt (k) zumindest im Bereich der Kontakte auf eine Temperatur $T_7$ mit 120 °C $\leq T_7 \leq$ 370 °C zum Verbinden der Kontakte mit elektrisch leitenden streifenförmigen Verbindern als Verfahrensschritt (1) erwärmt wird, wobei insbesondere das Halbleiterbauelement während des Verfahrensschritts (k) bzw. (l) Luft ausgesetzt wird, vorzugsweise in einem Verfahrensschritt (m) nach dem Verfahrensschritt (k) bzw. (l) auf Raumtemperatur abgekühlt wird.

10.  Verfahren nach zumindest Anspruch 1,
    **dadurch gekennzeichnet,**
    **dass** das Halbleiterbauelement mit weiteren Halbleiterbauelementen über Verbinder verschaltet und sodann in einem Verfahrensschritt (n) mit den weiteren Halbleiterbauelementen eingekapselt wird, wobei vorzugsweise der Verfahrensschritt (n) bzw. (II) bei einer Temperatur $T_8$ bzw. $T_{II}$ mit 70 °C $\leq T_8$, $T_{II} \leq$ 170 °C, vorzugsweise 130 °C $\leq T_8$, $T_{II} \leq$ 160 °C und/oder bei Unterdruck p mit 10 Pa $\leq$ p $\leq$ 1000 Pa absolut durchgeführt wird, und/oder dass den Kontakten vor oder während der Verkapselung (Verfahrensschritt (n) bzw. (II)) alkalische Komponenten zugeführt werden, wobei vorzugsweise die alkalischen Komponenten während des Verfahrensschritts (k) bzw. (II) den Kontakten zugeführt werden und insbesondere als alkalische Komponenten alkalische Salze wie Alkali oder Erdalkalikarbonate verwendet werden, wobei vorzugsweise zum Zuführen der alkalischen Komponenten die elektrisch leitenden Kontakte mit alkalischen Komponenten enthaltenen Polymeren kontaktiert werden.

11.  Verfahren nach zumindest Anspruch 1,
    **dadurch gekennzeichnet,**
    **dass** das Sintern des Materials (Verfahrensschritt (c)) derart durchgeführt wird, dass die hergestellten Kontakte jeweils aus Schichten unterschiedlicher Porositäten bestehen, wobei vorzugsweise zumindest äußerste Schicht des gesinterten Kontakts offenporig ausgebildet wird und insbesondere zumindest in der äußersten Schicht ein Porenvolumen von 10 vol.% bis 40 vol.%, insbesondere von 25 vol.% erzeugt wird, und wobei bevorzugterweise in die offenen Poren die alkalischen Komponenten eingebracht und sodann die Kontakte mit einer metallischen Schicht zumindest bereichsweise abgedeckt werden, die vorzugsweise galvanisch aufgebracht wird.

12.  Verfahren nach zumindest Anspruch 1,
    **dadurch gekennzeichnet,**
    **dass** das feuchte Material in pastenförmiger Konsistenz bzw. als Paste durch Drucken, Dispensen, Inkjet oder durch nasschemische Abscheideverfahren auf die Oberfläche des Halbleiterbauelements aufgebracht wird, insbesondere dass als feuchtes Material eine ein Lösungsmittel enthaltende pastenförmige Substanz verwendet wird, die Metalle wie Aluminum, Silber, Kupfer, Chrom, Vanadium, Palladium, Titan, Molybdän sowie Gläser vorzugsweise enthaltend metallische Oxide, Halbmetall, Bor, Phosphor sowie Keramiken wie $SiO_2$, Boroxid, $Al_2O_3$, $Al_xO_y$, SiC, $Si_3Nx$ sowie Kohlenstoff unterschiedlicher Morphologie wie Ruß, Graphit, Nanotubes, Fullerene enthält.

13.  Verfahren nach zumindest Anspruch 2,
    **dadurch gekennzeichnet,**

**dass** der Verfahrensschritt (III) über die Zeit $t_{III}$ mit 1 sec. $\leq t_{III} \leq 600$ sec. durchgeführt wird, und/oder

**dass** der Verfahrensschritt (III) bei einer Temperatur $T_{III}$ mit 20 °C $\leq T_{III} \leq 90$ °C durchgeführt wird, und/oder

**dass** der Verfahrensschritt (IV) über die Zeit $t_{IV}$ mit 1 sec. $\leq t_{IV} \leq 600$ sec. durchgeführt wird, und/oder

**dass** der Verfahrensschritt (IV) bei einer Temperatur $T_{IV}$ mit -40 °C $\leq T_{IV} \leq 20$ °C durchgeführt wird.

14. Verfahren nach zumindest Anspruch 1 oder 2,
**dadurch gekennzeichnet,**
**dass** als Halbleiterbauelemente solche verwendet werden, die eine Materialkonstante K[J/cm$^2$ °C] mit 0,02 $\leq$ K $\leq$ 0,06 aufweisen, wobei

$$K = A \times d \times \rho \times Cp \times B$$

mit:

A = Fläche des Halbleiterbauelements [cm$^2$],
d = Dicke des Halbleiterbauelements [cm],
$\rho$ = Dichte des Halbleiterbauelements [g/cm$^3$],
Cp = Wärmekapazität des Halbleiterbauelements [J/gK],
B = Bezugsgröße auf [1/cm$^2$] des jeweils zu behandelnden Halbleiterbauelements,
und **dass** die Halbleiterbauelemente zur Erzielung eines Wärmeinhalts P mit P = K $\cdot$ $\Delta$T $\cdot$ $\Delta$t in den einzelnen Verfahrensschritten über eine Zeit $\Delta$t einer Temperatur $\Delta$T ausgesetzt werden, wobei $\Delta$T die Temperaturdifferenz zu 0 °C ist, und/oder dass als verschaltete Halbleiterbauelemente solche verwendet werden, die eine Materialkonstante K*[J/cm$^2$ °C] mit 0,9 $\leq$ K* $\leq$ 1,6 aufweisen, wobei

$$K^* = A^* \times d^* \times \rho^* \times Cp^* \times B^*$$

mit:

A* = Fläche der verschalteten Halbleiterbauelemente [cm2],
d* = Dicke der verschalteten Halbleiterbauelemente [cm],
$\rho$* = Dichte der verschalteten Halbleiterbauelemente [g/cm3],
Cp* = Wärmekapazität der verschalteten Halbleiterbauelemente [J/gK],
B* = Bezugsgröße auf [1/cm$^2$] der verschalteten Halbleiterbauelemente wie Solarmodul,

und **dass** die verschalteten Halbleiterbauelemente zur Erzielung eines Wärmeinhalts P* mit P* = K* $\cdot$ $\Delta$T $\cdot$ $\Delta$t in den einzelnen Verfahrensschritten über eine Zeit $\Delta$t einer Temperatur $\Delta$T ausgesetzt werden, wobei $\Delta$T die Temperaturdifferenz zu 0 °C ist.

15. Verfahren nach zumindest Anspruch 14,
**dadurch gekennzeichnet,**
**dass** beim Verfahrensschritt (a) das Halbleiterbauelement einen Wärmeinhalt P erfährt mit 0,4 J s/cm$^2$ $\leq$ P $\leq$ 720 J s/cm$^2$, und/oder

**dass** beim Verfahrensschritt (b) das Halbleiterbauelement einen Wärmeinhalt P erfährt mit 2 J s/cm$^2$ $\leq$ P $\leq$ 10800 J s/cm$^2$, und/oder

**dass** beim Verfahrensschritt (c) das Halbleiterbauelement einen Wärmeinhalt P erfährt mit 288 J s/cm$^2$ $\leq$ P $\leq$ 4416 J s/cm$^2$, und/oder

**dass** beim Verfahrensschritt (d) das Halbleiterbauelement einen Wärmeinhalt P erfährt mit 0,4 J s/cm$^2$ $\leq$ P $\leq$ 1440 J s/cm$^2$, und/oder

**dass** beim Verfahrensschritt (e) das Halbleiterbauelement einen Wärmeinhalt P erfährt mit -1,2 J s/cm$^2$ $\leq$ P $\leq$ 86400 J s/cm$^2$, und/oder

**dass** beim Verfahrensschritt (i) das Halbleiterbauelement einen Wärmeinhalt P erfährt mit 7 J s/cm$^2$ $\leq$ P $\leq$ 3456 J s/cm$^2$, und/oder

**dass** beim Verfahrensschritt (1) das Halbleiterbauelement einen Wärmeinhalt P erfährt mit 0,24 J s/cm$^2$ $\leq$ P $\leq$ 333 J s/cm$^2$, und/oder

**dass** beim Verfahrensschritt (m) das Halbleiterbauelement einen Wärmeinhalt P erfährt mit 117000 J s/cm$^2$ ≤ P ≤ 460800 J s/cm$^2$, und/oder

**dass** beim Verfahrensschritt (n) das Halbleiterbauelement einen Wärmeinhalt P erfährt mit 117000 J s/cm$^2$ ≤ P ≤ 460800 J s/cm$^2$, und/oder

**dass** beim Verfahrensschritt (I) der Verbund der Halbleiterbauelemente einen Wärmeinhalt P* erfährt mit 0,24 J s/cm$^2$ ≤ P* ≤ 333 J s/cm$^2$, und/oder

**dass** beim Verfahrensschritt (II) der Verbund der Halbleiterbauelemente einen Wärmeinhalt P* erfährt mit 117000 J s/cm$^2$ ≤ P* ≤ 460800 J s/cm$^2$, und/oder dass beim Verfahrensschritt (III) der Verbund der Halbleiterbauelemente einen Wärmeinhalt P* erfährt mit 10 J s/cm$^2$ ≤ P* ≤ 81000 J s/cm$^2$, und/oder dass beim Verfahrensschritt (IV) der Verbund der Halbleiterbauelemente einen Wärmeinhalt P* erfährt mit -20 J s/cm$^2$ ≤ P* ≤ 18000 J s/cm$^2$.

Fig. 1

EP 2 280 425 A2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9124934 A
- US 6312864 B
- US 6322620 B
- JP 63268773 A

- WO 2005088730 A
- DE 102005026176 B
- DE 102006005026 A


**In der Beschreibung aufgeführte Nicht-Patentliteratur**

- **D. Pysch et al.** Comprehensive analysis of advanced solar cell contacts consisting of printed fine-line seed layers thickened by silver plating. *Progress in Photovoltaics: Research and Applications,* vol. 17, 101-114